**Europäisches Patentamt**

(19) **European Patent Office**

**Office européen des brevets**

(11) Numéro de publication: **0 127 526**
**B1**

(12) **FASCICULE DE BREVET EUROPEEN**

(45) Date de publication du fascicule du brevet:
28.10.87

(21) Numéro de dépôt: **84401025.6**

(22) Date de dépôt: **18.05.84**

(51) Int. Cl.⁴: **H 03 H 2/00**

(54) **Dispositif de filtrage à ondes magnétostatiques.**

(30) Priorité: **27.05.83 FR 8308828**

(43) Date de publication de la demande:
**05.12.84 Bulletin 84/49**

(45) Mention de la délivrance du brevet:
**28.10.87 Bulletin 87/44**

(84) Etats contractants désignés:
**DE GB NL**

(56) Documents cités:
**ELECTRONICS, vol. 56, no. 1, 13 janvier 1983, New York, US; R.T.GALLAGHER: "Planar technology readies challenge to YIG spheres", pages 85-86**
**MICROWAVE JOURNAL, vol. 25, no. 2, février 1982, Dedham, Mass. (US); J.D.ADAM et al.: "Magnetostatic wave devices", pages 95-99**
**ELECTRONICS LETTERS, vol. 18, no. 15, juillet 1982, Londres (GB); G.OHM et al.: "750 MHz microstrip bandpass filter on barium tetratinate substrate"**

(73) Titulaire: **THOMSON-CSF, 173, Boulevard Haussmann, F-75379 Paris Cédex 08 (FR)**

(72) Inventeur: **Castera, Jean-Paul, THOMSON-CSF SCPI 173, bld Haussmann, F-75379 Paris Cedex 08 (FR)**
Inventeur: **Dupont, Jean-Marie, THOMSON-CSF SCPI 173, bld Haussmann, F-75379 Paris Cedex 08 (FR)**

(74) Mandataire: **Wang, Pierre et al, THOMSON-CSF SCPI 173, Bld Haussmann, F-75379 Paris Cedex 08 (FR)**

### Description

La présente invention se rapporte aux dispositifs à propagation d'ondes magnétostatiques le long d'une couche ferrimagnétique déposée sur un substrat. Parmi ces dispositifs, il en existe qui fonctionnent au moyen de transducteurs en forme de microrubans pour émettre ou recevoir des ondes magnétostatiques de surface ou de volume. L'invention vise plus particulièrement des dispositifs de filtrage permettant, dans une plage de fréquence large, de transmettre sélectivement des ondes magnétostatiques ayant une longueur d'onde prédéterminée. En effet, les dispositifs à ondes magnétostatiques sont accordables au moyen d'un champ magnétique et peuvent fonctionner à une longueur d'onde donnée tout en conservant la possibilité de changer la fréquence. Le problème se pose d'atténuer la transmission des ondes magnétostatiques à des longueurs d'ondes qui s'écartent d'une valeur présélectionnée, ce problème est rencontré dans certaines applications où un réseau réflecteur ou un résonateur à cavité détermine par dimensionnement géométrique une longueur d'onde de fonctionnement à laquelle peut correspondre une gamme de fréquences. Cette particularité des ondes magnétostatiques résulte des propriétés dispersives et de l'accord par champ magnétique, caractéristique qui n'ont pas d'équivalent dans les dispositifs à ondes élastiques où la vitesse de propagation des ondes de Rayleigh est constante. Dans le domaine des dispositifs à ondes magnétostatiques, il est connu d'atténuer à l'émission ou à la réception les ondes magnétostatiques dont la longueur d'onde s'écarte d'une valeur assignée en adoptant une configuration repliée en U des microrubans. Cette technique n'est applicable qu'à un domaine de fréquence limité, car elle suppose que les courants circulant dans les deux branches de l'U, distantes de $\lambda/2$, soient en opposition de phase.

Les solutions qui consistent à utiliser une configuration des transducteurs d'émission ou de réception, telle que la transmission aux grandes longueurs d'ondes magnétostatiques soit amoindrie, ont l'inconvénient d'introduire un retard qui ne dépend pas du champ magnétique réalisant l'accord en fréquence. Dans un montage à oscillateur accordable, cet inconvénient tend à limiter la plage d'accord et à donner naissance à des sauts de mode.

Les dispositifs de filtrage selon l'invention permettent de pallier les inconvénients cités ci-dessus.

L'invention propose d'introduire sur le trajet de propagation des ondes magnétostatiques un microruban conducteur dont la largeur à la longueur d'onde magnétostatique $\lambda$ assure un effet transducteur quasi nul, mais qui prend de l'importance dès que la longueur d'onde s'écarte de la valeur que l'on désire transmettre sans pertes. Ainsi, les longueurs d'ondes pour lesquelles l'effet transducteur est notable sont atténués grâce à un moyen dissipatif approprié qui coopère avec le microruban. Ce microruban constitue un dispositif de filtrage disposant d'une «fenêtre de transmission» étroite qui coïncide avec une longueur d'onde de coupure de l'effet transducteur qu'il peut développer à d'autres longueurs d'ondes.

L'invention a pour objet un dispositif de filtrage transmettant des ondes magnétostatiques de longueur d'onde prédéterminé, ces ondes magnétostatiques se propageant dans une couche magnétique épitaxiée sur une couche non magnétique, caractérisé en ce qu'il comprend au moins un microruban de filtrage placé sur le trajet desdites ondes; la largeur dudit microruban étant égale à un multiple de la longueur d'onde à transmettre sélectivement; des moyens dissipatifs associés audit microruban dissipant l'énergie provenant de l'interaction des ondes magnétostatiques avec ledit microruban de filtrage lorsque la longueur d'onde desdites ondes s'écarte de la longueur d'onde ($\lambda r$) désirée.

L'invention sera mieux comprise au moyen de la description ci-après et des figures annexées parmi lesquelles:

la fig. 1 représente une configuration typique de transducteurs à ondes magnétostatiques;
la fig. 2 est un diagramme explicatif;
les fig. 3 à 7 sont des diagrammes explicatifs;
la fig. 8 est une vue isométrique d'un dispositif de filtrage selon l'invention;
la fig. 9 est un diagramme explicatif;
la fig. 10 est un schéma explicatif.

La fréquence des ondes magnétostatiques de volume directives est liée au champ magnétique appliqué H par la formule:

$$f = \gamma \left(H - 4\pi M\right) \left[ H - \frac{\alpha 2}{(1 + \alpha 2)} \right) 4 M \right] \right\} \Delta$$ où $\gamma$ est le rapport gyromagnétique, $4\pi M$ est l'aimantation du matériau, et où $\alpha$ est tiré de l'expression:

$$\mathrm{tg}\left(\frac{\alpha\, kd}{2}\right) = \frac{1}{\alpha}$$

avec $k = 2\pi/\lambda$, $\lambda$ la longueur d'onde et d l'épaisseur de la couche magnétique.

Pour les ondes magnétostatiques de volume contradirectives (backward) $\alpha$ vérifierait la relation:

$$2\,\mathrm{cotg}\,(\alpha kd) = \alpha - \alpha^{-1}$$

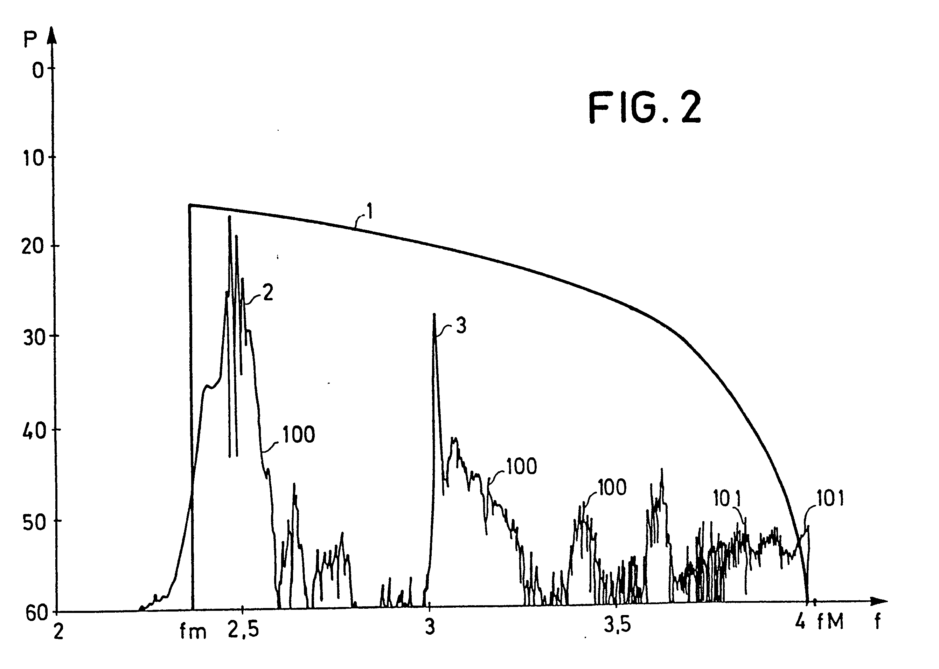

A titre indicatif, sur le diagramme de la figure 2, la courbe 1 représente la fonction de transfert d'une ligne à retard à ondes magnétostatiques. Cette courbe montre que la propagation s'établit avec une longueur d'onde infinie à la fréquence minimale:

$$f_m = \gamma(H - 4\pi M)$$

La fréquence maximale $f_M$ est donnée par la relation:

$$f_M = \gamma \sqrt{H(H - 4\pi M)}$$

Les pertes d'insertion croissent entre $f_m$ et $f_M$.

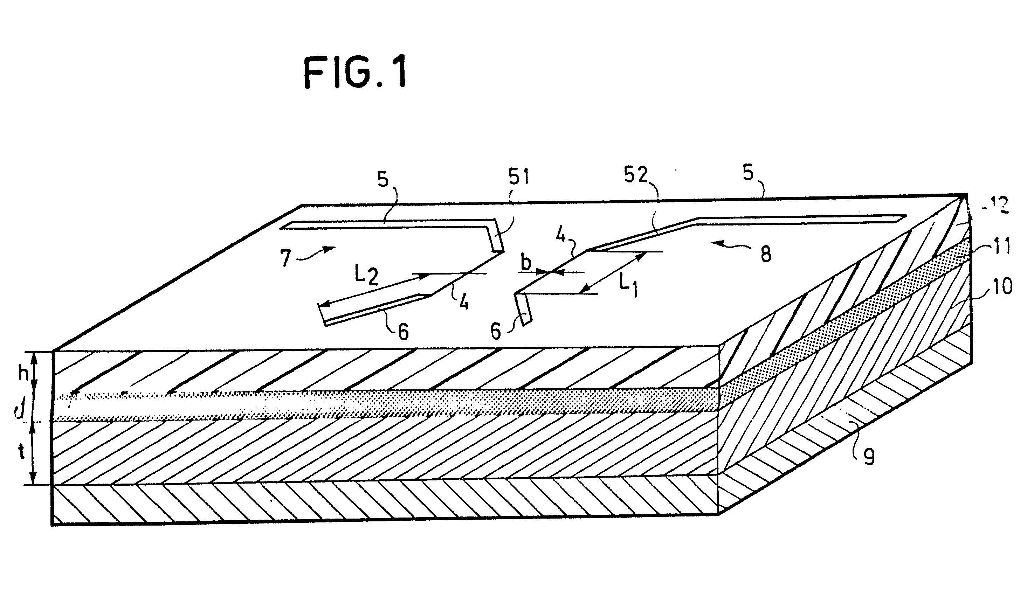

Sur la figure 1, on peut voir une ligne de transmission à ondes magnétostatiques comportant des transducteurs 7 et 8. Chaque transducteur comporte une connexion électrique 5 d'entrée ou de sortie qui se prolonge par un ruban 4 émetteur ou récepteur d'ondes magnétostatiques et qui se termine par une connexion électrique 6 constituant une charge terminale. Les rubans 4 ont une longueur $L_1$ et une largeur b. La demi longueur du ruban 4 additionnée à la longueur de la connexion d'extrémité 6 a pour valeur $L_2$.

Les connexions d'extrémité 6 et les parties 51 et 52 des connexions 5 proches des rubans 4 sont agencées obliquement de façon à minimiser le couplage électromagnétique. Ce couplage électromagnétique est minimal quand les connexions 51–52 et les connexions 6 des transducteurs 7 et 8 sont disposés orthogonalement. Les transducteurs 7 et 8 sont agencés à la surface d'une structure comportant un substrat 10 de grenat de gadolinium et gallium (GGG) d'épaisseur t. Le dos du substrat 10 est recouvert d'une métallisation 9. Une couche 11 de grenat d'yttrium et de fer (YIG) ayant une épaisseur d est épitaxiée sur le substrat 10. Sur la couche 11 de YIG est déposée une couche diélectrique 12 d'épaisseur h, servant de support aux microrubans. La couche 10 de GGG comporte sur sa face inférieure une métallisation 9 constituant une masse électrique.

La figure 2 représente la fonction de transfert 1 d'une ligne à retard et la fonction de transfert 100 d'un résonateur. Ces fonctions de transfert qui concernent des dispositifs à ondes magnétostatiques de volume directives (forward) ont été obtenues à champ magnétique H constant. Les diagrammes de la figure 2 donnent en fonction de la fréquence f exprimée en GHz, les pertes d'insertion P exprimées en dB d'un dispositif à ondes magnétostatiques de volume «forward».

Un résonateur à ondes magnétostatiques de volume a été décrit dans le document «Planar Technology readies challenge to YIG sphères» de Robert T. Gallagher publié dans Electronics, volume 56, numéro 1, 13 janvier 1983, pages 85 et 86. La fonction de transfert représentée par la courbe 100 correspond au fonctionnement à la longueur d'onde de 300 µm. A la fréquence de 3 GHz, on observe un pic de résonance 3 correspondant à des pertes d'insertion de 26 dB. Aux fréquences correspondant aux grandes longueurs d'ondes magnétostatiques, on observe les pics 2 qui correspondent à des pertes d'insertion moindres.

Les paramètres t, d, h, b, $L_1$ et $L_2$ illustrés sur la figure 1 servent de base pour le calcul des pertes d'insertion d'une ligne à retard construite en accord avec les schémas des figures 1 et 2. Pour cela, on calcule les pertes d'insertion $P_1$ d'un transducteur tel qu'illustré par la figure 1 et ensuite les pertes $P_2$ d'une ligne à retard à deux transducteurs. On a:

$$P_1 = 10 \log_{10}\left(\frac{4\,Ri\,Rg}{(Ri + Rg)^2 + Xi^2}\right)$$

$$P_2 = 20 \log_{10}\left(\frac{(Ri + Rg)^2 + Xi^2}{2\,Ri\,Rg}\right) + 76{,}4\,\Delta\,HT,$$

P est exprimée en dB, $\Delta H$ est la largeur de raie exprimée en œrsteds, T est le retard de la ligne exprimé en microseconde, Rg est la résistance interne du générateur, Ri est la partie réelle de l'impédance d'entrée du transducteur, Xi est la partie imaginaire de l'impédance du transducteur. On a:

$$Ri = \frac{Rm \cdot L_1}{2}$$

et $Xi = -Zc\,\cotg(\beta L_2)$, où Rm est la résistance de radiation du transducteur considéré, Zc est l'impédance caractéristique de la ligne et $\beta$ la constante de propagation des ondes électromagnétiques dans le microruban. Zc et $\beta$ sont données par les expressions suivantes:

$$Zc = \frac{60}{\sqrt{\varepsilon\,eff}}\,\ln\left(8\,\frac{t + d + h}{b} + 0{,}25\,\frac{b}{t + d + h}\right)$$

avec

$$\varepsilon\,eff = \frac{\varepsilon r + 1}{2} + \frac{\varepsilon r - 1}{2}\left[(1 + 12\,\frac{t + d + h}{b})^{-\frac{1}{2}} + 0{,}04\,(1 - \frac{b}{t + d + h})^2\right]$$

et

$$\beta = \frac{2\pi f\sqrt{\varepsilon\,eff}}{c}$$

c est la célérité de la lumière dans le vide et $\varepsilon r$ la constante diélectrique du YIG déposé sur le GGG. De plus, on a

$$\frac{Rm}{2} = \mu_o \omega j_k^2\,K(h)\ \text{où}\ \omega = 2\pi f\ \text{et}\ j_k$$

la transformée de Fourier de la densité de courant, $\mu_o$ est la perméabilité magnétique et K(h) vérifie la formule:

$$K(h) = K\exp(-2kh)$$

avec

$$K = \frac{(th^2 kt - \mu_{11})(1 - \mu_{11})^{-2}}{2kd\,[th^2 kt - \mu_{11} - \frac{t}{d}(1 - th^2 kt)]}$$

Dans cette formule:

$$\mu_{11} = 1 - \frac{\Omega H}{\Omega^2 - \Omega^2_H}$$

$$\Omega = \frac{f}{\gamma\,4\pi M}$$

$$\Omega_H = \frac{H - 4\pi M}{4\pi M}$$

et k, le nombre d'onde.

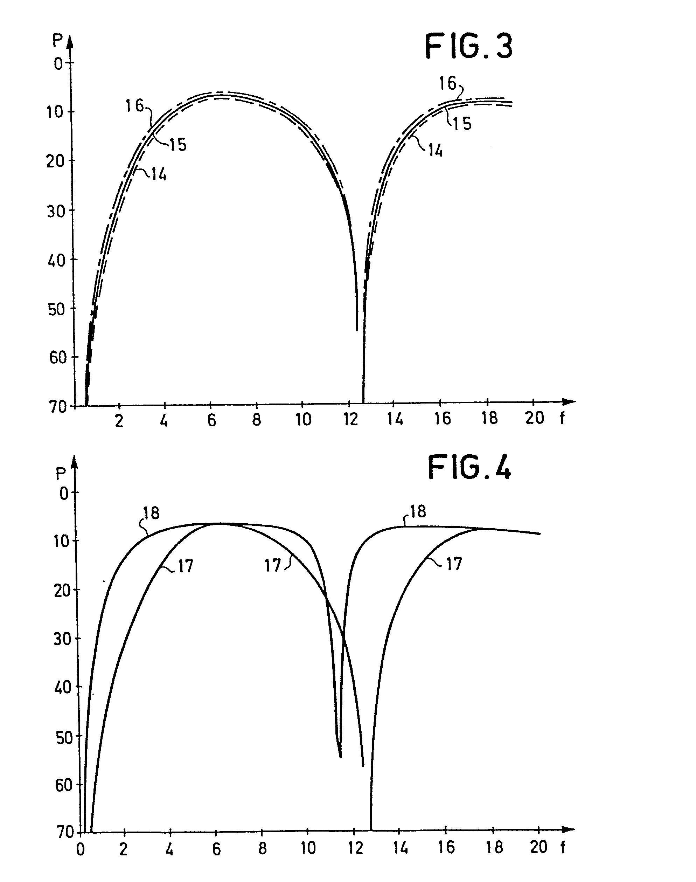

En prenant pour base les formules qui précèdent, on procède à des calculs qui font apparaître comment évoluent les pertes d'insertion d'un transducteur à microruban du type illustré sur la figure 1. Il s'agit d'une ligne de transmission à ondes magnétostatiques de volume progressives utilisant deux transducteurs identiques; ainsi les pertes d'insertion de la ligne sont représentatives des pertes d'insertion propres au transducteur d'émission ou de réception. Les calculs effectués permettent d'établir un jeu de diagrammes illustrant l'influence des paramètres de la ligne de transmission sur des pertes d'insertion. Ces diagrammes sont présentés aux figures 3 à 7 et expriment la variation des pertes d'insertion P en décibels en fonction de la fréquence f des ondes magnétostatiques en gigaherz. Lorsque cela est nécessaire pour maintenir constant le paramètre étudié, la variation de fréquence est accompagnée d'une variation de l'intensité du champ magnétique de polarisation de la couche magnétique. Il en est ainsi, lors d'un fonctionnement à longueur d'onde magnétostatique constante, mais il va sans dire que cette coordination entre les valeurs de fréquence et de champ magnétique ne concerne pas la longueur d'onde électromagnétique qui définit l'évolution du courant circulant le long des microrubans.

Sur la figure 3 on peut voir les pertes d'insertion P exprimées en dB, en fonction de la fréquence f exprimée en GHz d'un couple de transducteurs d'ondes magnétostatiques. La variation de fréquence a été associée à une variation du champ magnétique H. Les transducteurs sont réalisés avec les dimensions suivantes: b = 30 µm, $L_1$ = 3 mm, $L_2$ = 4,5 mm. En outre, le milieu de propagation pris en considération est dimensionné comme suit: d = 20 µm, t = 200 µm, h = 0.

Les courbes 14, 15 et 16 de la figure 3 ont été respectivement obtenues pour des longueurs d'ondes λ = 300 µm, λ = 10 mm et λ = 1 m; on voit qu'elles sont quasiment confondues. On peut donc tirer la conclusion que le transducteur microruban de largeur b = 30 µm n'est pas sélectif en fonction de la longueur d'onde magnétostatique λ.

On note sur la figure 3 que les courbes 14, 15 et 16 représentent au voisinage de la fréquence 12 GHz une région à fortes pertes d'insertion, c'est-à-dire à couplage pratiquement nul. Il s'agit là d'un effet de coupure lié à la distribution du courant le long du transducteur. Il arrive que le régime d'ondes stationnaires conditionné par la longueur d'onde électromagnétique λem donne lieu à des variations en sens contraire du courant qui annulent la capacité à rayonner du microruban.

Sur la figure 4, on peut voir les pertes d'insertion P en fonction de la fréquence f pour une grande longueur d'onde égale à un mètre. La courbe 17 correspond à des microrubans de largeur b = 30 µm. La courbe 18 correspond à une largeur b = 1 mm.

Les autres paramètres sont les suivants: d = 20 µm, t = 500 µm, h = 0, $L_1$ = 3 mm, $L_2$ = 4,5 mm.

Lorsque la longueur d'onde magnétostatique est grande, on voit qu'un microruban large occasionne moins de pertes d'insertion qu'un microruban étroit, de largeur b = 30 µm.

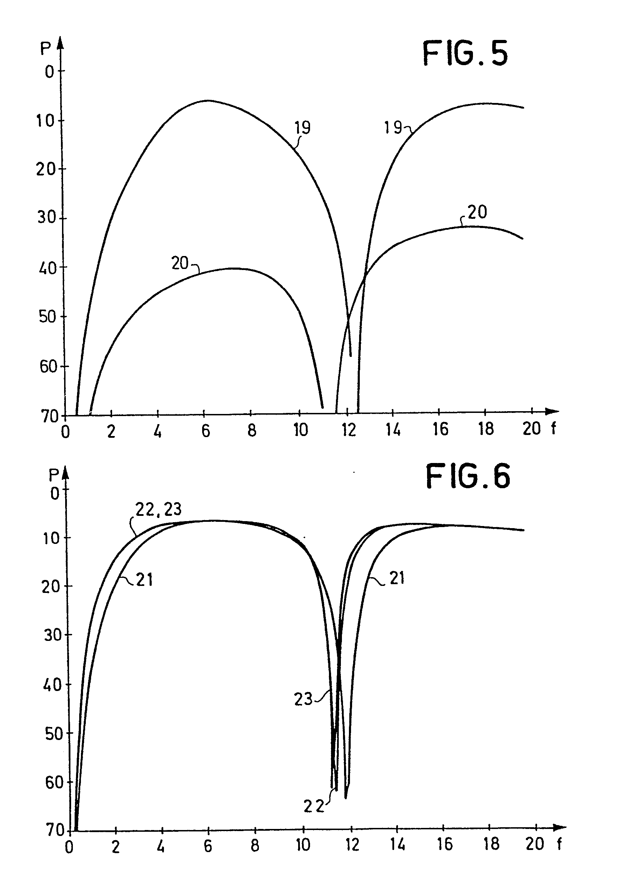

L'interprétation du diagramme de la figure 4 montre que le couplage des grandes longueurs d'ondes est beaucoup plus efficace avec un microruban large qu'avec un microruban étroit. On est donc amené à réaliser la fonction de filtrage avec un ruban large pour absorber efficacement les grandes longueurs d'ondes, mais à choisir cette largeur de telle façon que la longueur d'onde λr à transmettre corresponde à un très faible couplage. Cette condition est réalisée conformément à l'invention en adoptant une largeur b de microruban égale à un multiple de $λ_r$. Cette disposition avantageuse est mise en évidence par le diagramme de la figure 5 qui représente l'évolution des pertes d'insertion pour la longueur d'onde de $λ_r$ = 300 µm. Le diagramme de la figure 5 correspond aux paramètres suivants: d = 20 µm, t = 500 µm, h = 0, $L_1$ = 3 mm, et $L_2$ = 4,5 mm.

La courbe 19 correspond à une largeur b = 30 µm. La courbe 20 correspond à une largeur b = 1 mm et montre que les pertes d'insertion sont très sensiblement accrues. La figure 5 ne montre pas les pertes d'insertion relatives à un microruban de largeur b = 900 µm, car ces pertes dépassent 70 dB dans toute la plage de fréquences. Ainsi, les pertes d'insertion du couple de microrubans de largeur b = nλ où n est un entier strictement positif sont très importantes et conformément à l'invention, cette absence très sélective de couplage va servir de fenêtre de transparence pour filtrer les ondes magnétostatiques.

Il reste à vérifier que l'utilisation d'un microruban de largeur b = nλ conduit à un couplage efficace aux grandes longueurs d'ondes.

Sur la figure 6, on peut voir les pertes d'insertion P d'un couple de microrubans de largeur b = 900 µm placés sur une couche isolante 12 dont l'épaisseur h prend trois valeurs. La longueur d'onde est choisie égale à 1 mètre et les autres paramètres sont: d = 20 µm, t = 500 µm, $L_1$ = 3 mm et $L_2$ = 4,5 mm.

La courbe 21 correspond à une épaisseur h = 900 µm. La courbe 22 correspond à une épaisseur h = 30 µm. La courbe 23 est basée sur l'hypothèse d'un montage de transducteurs à même la couche magnétique. En comparant ces courbes, on voit que l'épaisseur h influe peu aux grandes longueurs d'ondes sur l'efficacité du couplage.

Le dispositif selon l'invention fonctionne convenablement si l'on interpose entre les microrubans et la couche 11 de YIG un diélectrique 12 d'épaisseur h = 200 µm par exemple.

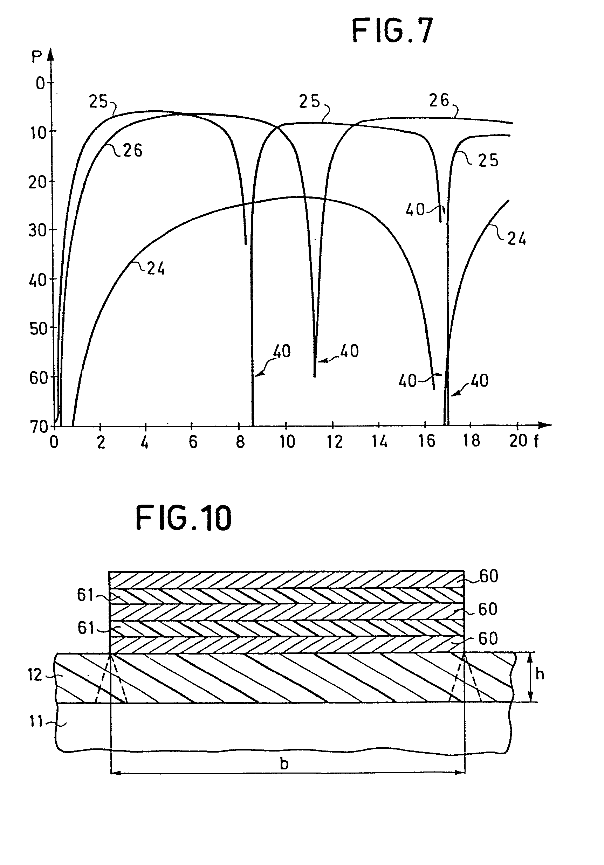

Pour terminer, la figure 7 montre les pertes d'insertion P d'un couple de microrubans pour une longueur d'onde magnétostatique de 1 mètre lorsqu'on fait varier les longueurs $L_1$ et $L_2$ des parties constitutives des microrubans. Les autres paramètres sont: d = 20 µm, t = 500 µm, b = 900 µm et h = 0.

La courbe 24 correspond à une longueur $L_1$ = 0,1 mm et une longueur $L_2$ = 3,05 mm. La courbe 25 correspond à une longueur $L_1$ = 6 mm et une

longueur $L_2$ = 6 mm. La courbe 26 correspond à une longueur $L_1$ = 3 mm et une longueur $L_2$ = 4,5 mm.

On utilise de préférence des microrubans de longueur $L_1$ grande. Le choix de $L_1$ doit tenir compte des augmentations locales des pertes d'insertion dues aux phénomènes d'ondes stationnaires le long des microrubans. En effet, celles-ci doivent se trouver hors de la plage des longueurs d'ondes que le dispositif de filtrage selon l'invention est appelé à couvrir. De même, la longueur $L_2$ des microrubans peut être choisie pour que les augmentations locales des pertes d'insertion ne tombent pas dans cette plage de fréquence.

Le dispositif de filtrage selon l'invention utilise un microruban pour capter les ondes magnétostatiques de grande longueur d'onde en offrant un couplage négligeable vis-à-vis des ondes magnétostatiques dont la longueur d'onde est un sous multiple de la largeur b. On élimine l'énergie des ondes couplées efficacement en terminant le microruban par une charge résistive adaptée. Une autre solution consiste à utiliser des microrubans réalisés eux-mêmes dans un matériau dissipatif, par exemple du chrome. Avantageusement, le microruban est constitué d'un empilement de couches minces de chrome séparées par des couches diélectriques par exemple un verre. Une variante de l'invention est obtenue par des pulvérisations alternées d'un métal de résistivité élevée et d'un diélectrique.

Dans les dispositifs selon l'invention utilisant des transducteurs formés de couches multiples, l'épaisseur h du diélectrique 12 prise en compte dans les calculs est la distance séparant la surface du YIG 11 de la première couche de métal de résistivité élevée.

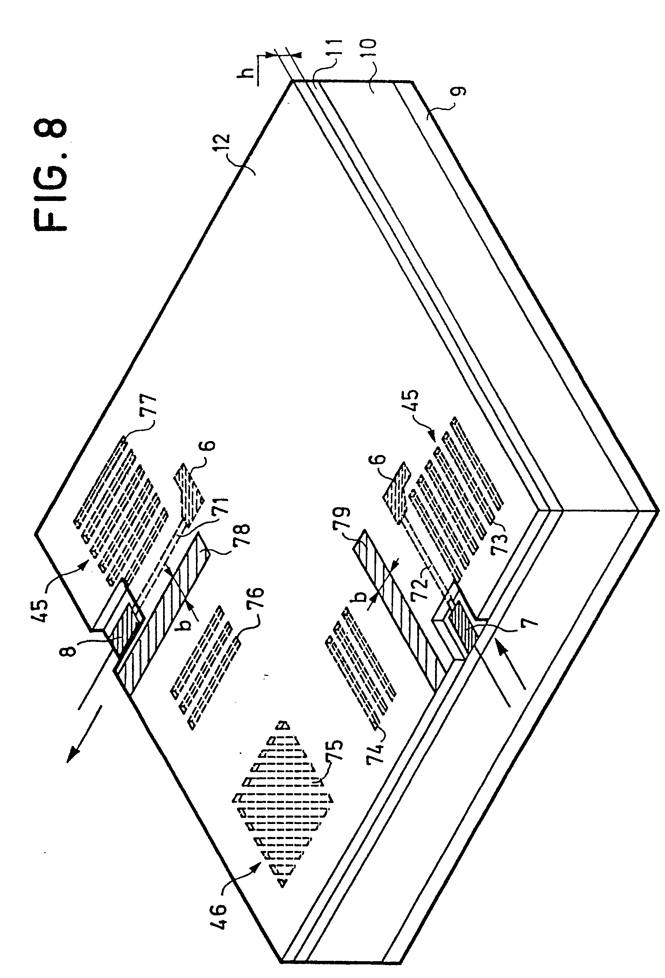

Sur la figure 8, on peut voir un résonateur à ondes magnétostatiques de volume «forward» équipé des microrubans de filtrage selon l'invention. Comme indiqué ci-dessus, un dispositif de ce genre a été décrit dans le document «Planar Technology readies challenge to YIG sphères» de Robert T. Gallagher publié dans Electronics, volume 56, numéro 1, 13 janvier 1983, pages 85 et 86. Dans l'exemple de la figure 8, les transducteurs d'entrée et de sortie sont des microrubans émetteurs et récepteurs 72 et 71 représentés en pointillé qui relient des bornes d'entrée et de sortie 7 et 8 à des terminaisons métalliques 6 pouvant former la masse électrique du dispositif. Le dispositif est réalisé en partant d'un bloc 10 de GGG, à la surface duquel a été déposée une couche 11 de YIG. Les microrubans émetteurs et récepteurs sont situés à la surface de la couche de YIG dans des cavités résonantes 45 délimitées par des réseaux réflecteurs. Les sillons composant ces réseaux sont usinés dans la couche de YIG 11. Un réseau de renvoi 46 lui aussi composé de sillons gravés dans la couche de YIG 11 est disposé pour réfléchir les ondes magnétostatiques provenant d'une cavité 45 vers l'autre cavité. Entre les bornes d'entrée et de sortie 7 et 8, le dispositif de la figure 8 peut être considéré comme un filtre permettant de sélectionner une longueur d'onde $\lambda_r$. Cette sélection résulte des cavités résonantes 45 dans lesquelles les réseaux de sillons 73, 74, 76 et 77 créent des modes longitudinaux dont l'un correspond à la longueur d'onde $\lambda_r$ du fonctionnement désiré. Pour parfaire cette sélection, les sillons 75 du réseau de renvoi 46 sont agencés pour renvoyer, à la longueur d'onde $\lambda_r$, les ondes qui émergent du réseau de sillons 74 vers le réseau de sillons 76. Ainsi les deux cavités résonantes 45 sont couplées par un moyen sélectif. Pour améliorer encore la sélection de la longueur d'onde $\lambda_r$, la structure de la figure 8 est revêtue de la couche diélectrique 12 sur laquelle sont agencés les moyens de filtrage selon l'invention. Comme exposé ci-dessus, ces moyens sont constitués de microrubans 78 et 79 dont la largeur b est multiple de la longueur d'onde $\lambda_r$. Dans le cas de la figure 8 les microrubans 78 et 79 sont réalisés en chrome, afin de dissiper l'énergie électrique dont ils sont le siège lorsque la longueur d'onde des ondes magnétostatiques s'écarte de la longueur d'onde $\lambda_r$ désirée. Le nombre de la position des microrubans peuvent être déterminés dans chaque cas suivant la géométrie du dispositif et le degré d'amortissement des ondes de grande longueur d'onde magnétostatique désiré.

Les divers microrubans de filtrage n'ont pas nécessairement la même largeur b. On peut par exemple utiliser un microrubans de largeur $3\lambda_r$ et deux microrubans de largeur $5\lambda_r$. Par adjonction d'un moyen amplificateur externe reliant les bornes 7 et 8, on transforme le résonateur de la figure 8 en un oscillateur accordable particulièrement performant. L'accord, par exemple entre 2,5 et 7 GHz, est effectué par variation du champ magnétique H.

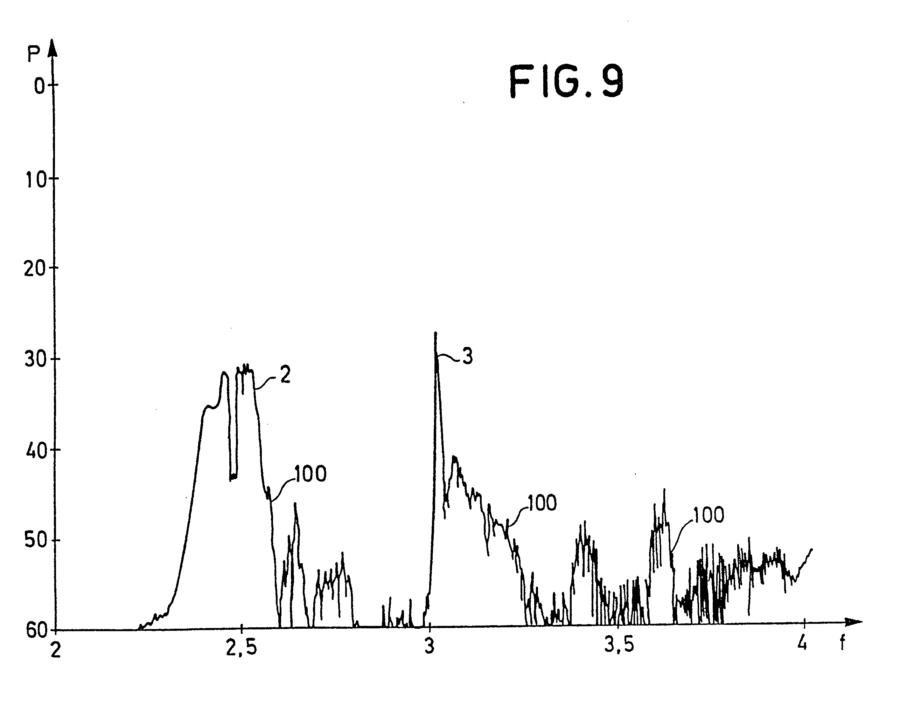

Sur la figure 9, on peut voir la fonction de transfert 100 d'un résonateur équipé de filtres selon l'invention. Cette fonction de transfert a été obtenue à champ magnétique H constant. Le pic 3 correspondant à la longueur d'onde de résonance $\lambda_r$ n'est pratiquement pas affecté par la présence des microrubans de filtrage. Par contre le pic 2 correspondant aux signaux parasites de grande longueur d'onde est diminué de 17 dB par rapport à ce qu'il serait dans le moyen de filtrage.

La courbe de la figure 9 a été obtenue pour une structure telle que représentée sur la figure 8 des microrubans de filtrage placés au-dessus des réseaux formant les cavités résonantes 45.

La figure 10 est une vue en coupe partielle d'un dispositif de filtrage selon l'invention.

L'existence de la couche 12 de diélectrique entre la couche 11 de YIG et les couches 60 qui forment le microruban de filtrage fait que la largeur b n'est pas exactement égale à un multiple de la longueur d'onde $\lambda_r$. Il faut tenir compte d'un effet de bord symbolisé sur la figure 10 par les zones délimitées par les lignes pointillées qui partent des bords de la couche métallique 60. Le dispositif de la figure 10 est constitué d'un empilage alterné de couches métalliques 60 et diélectriques 61.

L'invention n'est pas limitée aux ondes magnétostatiques de volume et s'applique aussi aux dispositifs à ondes magnétostatiques de surface.

Le dispositif selon l'invention s'applique notamment aux résonateurs, oscillateurs et lignes à retard à ondes magnétostatiques.

## Revendications

1. Dispositif de filtrage des ondes magnétostatiques de longueur d'onde ($\lambda_r$) prédéterminée, ces ondes magnétostatiques se propageant dans une couche magnétique (11) épitaxiée sur une couche non magnétique (10), caractérisé en ce qu'il comprend au moins un microruban de filtrage (78, 79, 60) placé sur le trajet desdites ondes; la largeur (b) dudit microruban étant égale à un multiple de la longueur d'onde ($\lambda_r$) à transmettre sélectivement; des moyens dissipatifs associés audit microruban dissipant l'énergie provenant de l'interaction des ondes magnétostatiques avec ledit microruban de filtrage lorsque la longueur d'onde desdites ondes s'écarte de la longueur d'onde ($\lambda_r$) désirée.

2. Dispositif selon la revendication 1, caractérisé par le fait qu'il comporte une couche diélectrique (12) entre ledit microruban (78, 79, 60) et la couche magnétique (11).

3. Dispositif selon l'une quelconque des revendications 1 ou 2, caractérisé en ce que lesdites ondes magnétostatiques sont échangées par des moyens transducteurs (71, 72) situés sur ladite couche magnétique (11); chacun desdits moyens transducteurs étant constitué par un microruban (4) formant la partie médiane d'un élément conducteur déposé sur ladite couche magnétique (11); les parties extrêmes dudit élément conducteur constituant une connexion d'extrémité (6) et une connexion électrique (5) d'entrée ou de sortie.

4. Dispositif selon la revendication 3, caractérisé en ce que les parties extrêmes d'un moyen transducteur sont agencées à angle droit par rapport aux parties extrêmes de l'autre moyen transducteur.

5. Dispositif selon l'une quelconque des revendications 3 et 4, caractérisé en ce que l'un au moins des microrubans (4) est situé à l'intérieur d'une cavité résonante (45) délimitée par deux réseaux réflecteurs (73, 74, 76, 77).

6. Dispositif selon la revendication 5, caractérisé en ce que deux microrubans (4) sont respectivement situés dans deux cavités résonantes (45) délimitées par des réseaux réflecteurs (73, 74, 76, 77); un réseau de renvoi (46) étant disposé pour renvoyer vers l'une desdites cavités résonantes (45) les ondes magnétostatiques émergeant de l'autre desdites cavités résonantes.

7. Dispositif selon la revendication 6, caractérisé en ce que les microrubans de filtrage sont localisés entre les réseaux réflecteurs (73, 74 et 76, 77) constituant chacune desdites cavités résonantes (45).

8. Dispositif selon l'une quelconque des revendications 1 à 7, caractérisé en ce que la dissipation de l'énergie provenant de l'interaction des ondes magnétostatiques avec ledit microruban de filtrage (78, 79, 60) est assurée par le matériau électriquement conducteur dont il est formé.

9. Dispositif selon la revendication 8, caractérisé en ce que ledit matériau électriquement conducteur est le chrome ou un alliage de nickel et de chrome.

10. Dispositif selon la revendication 8, caractérisé en ce que ledit matériau électriquement conducteur est subdivisé en couches superposées isolées par un diélectrique.

## Patentansprüche

1. Vorrichtung zum Filtern magnetostatischer Wellen einer vorbestimmten Wellenlänge ($\lambda_r$), wobei sich diese magnetostatischen Wellen in einer Magnetschicht (11) ausbreiten, die auf einer nichtmagnetischen Schicht (10) epitaktisch aufgebracht ist, dadurch gekennzeichnet, dass sie mindestens ein Filter-Mikroband (78, 79, 60) enthält, das auf dem Weg der Wellen liegt; wobei die Breite (b) des Mikrobandes gleich einem Vielfachen der Wellenlänge ($\lambda_r$) ist, die selektiv zu übertragen ist; wobei mit dem Mikroband verbundene dissipative Mittel die Energie abführen, die von der Wechselwirkung der magnetostatischen Wellen mit dem Filter-Mikroband herrührt, wenn die Wellenlänge der Wellen von der gewünschten Wellenlänge ($\lambda_r$) abweicht.

2. Vorrichtung nach Anspruch 1, dadurch gekennzeichnet, dass sie eine dielektrische Schicht (12) zwischen dem Mikroband (78, 79, 60) und der Magnetschicht (11) enthält.

3. Vorrichtung nach einem der Ansprüche 1 oder 2, dadurch gekennzeichnet, dass die magnetostatischen Wellen durch Wandlermittel (71, 72) ausgetauscht werden, die auf der magnetischen Schicht (11) liegen, wobei jedes der Wandlermittel durch ein Mikroband (4) gebildet wird, das den Mittelteil eines Leiterelements bildet, das auf der magnetischen Schicht (11) liegt; wobei die Endteile des Leiterelements eine Endverbindung (6) und eine elektrische Eingangs- oder Ausgangsverbindung (5) bilden.

4. Vorrichtung nach Anspruch 3, dadurch gekennzeichnet, dass die Endteile eines Wandlermittels rechtwinklig zu den Endteilen des anderen Wandlermittels angeordnet sind.

5. Vorrichtung nach einem der Ansprüche 3 und 4, dadurch gekennzeichnet, dass mindestens eines der Mikrobänder (4) im Inneren eines Resonanzhohlraums (45) liegt, der von zwei reflektierenden Rastern (73, 74, 76, 77) begrenzt wird.

6. Vorrichtung nach Anspruch 5, dadurch gekennzeichnet, dass zwei Mikrobänder (4) jeweils in zwei Resonanzhohlräumen (45) liegen, die von reflektierenden Rastern (73, 74, 76, 77) begrenzt werden; wobei ein Rücksenderaster (46) vorgesehen ist, um zum einen der beiden Resonanzhohlräume (45) die vom anderen der beiden Resonanzhohlräume austretenden magnetostatischen Wellen zurückzusenden.

7. Vorrichtung nach Anspruch 6, dadurch gekennzeichnet, dass die Filter-Mikrobänder zwischen den reflektierenden Rastern (73, 74 und 76, 77) liegen, die jeden der Resonanzhohlräume (45) bilden.

8. Vorrichtung nach einem der Ansprüche 1 bis 7, dadurch gekennzeichnet, dass die Abfuhr der Energie, die von der Wechselwirkung der magnetostatischen Wellen mit dem Filter-Mikroband (78, 79, 60) herrührt, durch das elektrischleitende Material sichergestellt wird, aus dem es gebildet ist.

9. Vorrichtung nach Anspruch 8, dadurch gekennzeichnet, dass das elektrischleitende Material Chrom oder eine Nickel-Chrom-Legierung ist.

10. Vorrichtung nach Anspruch 8, dadurch gekennzeichnet, dass das elektrischleitende Material in übereinanderliegende Schichten unterteilt ist, die durch ein Dielektrikum isoliert sind.

## Claims

1. Device for filtering magnetostatic waves of predetermined wave length $(\lambda_r)$, these magnetostatic waves propagating in a magnetic layer (11) epitaxially formed on a non-magnetic layer (10) characterized in that it comprises at least one filtering microstrip (78, 79, 60) located on the path of these waves; the width (b) of said microstrip being equal to a multiple of the wave length $(\lambda_r)$ to be selectively transmitted; dissipating means associated with said microstrip dissipating the energy originating from the interaction of the magnetostatic waves with said filtering microstrip when the wavelength of said waves deviates from the desired wave length $(\lambda_r)$.

2. Device according to claim 1, characterized by the fact that it comprises a dielectric layer (12) between said microstrip (78, 79, 60) and the magnetic layer (11).

3. Device according to any of claims 1 or 2, characterized in that said magnetostatic waves are exchanged by transducer means (71, 72) located on said magnetic layer (11); each of said transducer means being constituted by a microstrip (4) forming the centre portion of a conductive element deposited on said magnetic layer (11); the end portions of said conductive element forming an end connection (6) and an electric input or output connection (5).

4. Device according to claim 3, characterized in that the end portions of a transducer means are arranged at right angles with respect to the end portions of the other transducer means.

5. Device according to any of claims 3 and 4, characterized in that at least one of the microstrips (4) is located inside of a resonant cavity (45) defined by two reflecting patterns (73, 74, 76, 77).

6. Device according to claim 5, characterized in that two microstrips (4) are respectively located insode of two resonant cavities (45) defined by reflecting patterns (73, 74, 76, 77); a deflecting pattern (46) being arranged to redirect the magnetostatic waves emerging of one of said resonant cavities to the other (45) of said resonant cavities.

7. Device according to claim 6, characterized in that the filtering microstrips are located between the reflecting pattern (73, 74 and 76, 77) forming each of said resonant cavities (45).

8. Device according to any of claims 1 to 7, characterized in that the dissipation of the energy originating from the interaction of the magnetostatic waves with the filtering microstrip (78, 79, 60) is ensured by the electrically conductive material whereof it is formed.

9. Device according to claim 8, characterized in that said electrically conductive material is chromium or a nickel-chromium alloy.

10. Device according to claim 8, characterized in that said electrically conductive material is subdivided in superimposed layers insulated by a dielectric.

# FIG.1

FIG. 2

FIG.3

FIG.4

FIG.5

FIG.6

# FIG.7

# FIG.10

FIG. 8

FIG.9